# EUROPEAN PATENT APPLICATION

(11) **EP 4 730 576 A1**
(43) Date of publication of application: **22.04.2026**
(21) Application number: 23941581.3
(22) Date of filing: 14.06.2023
(51) Int. Cl.: H01S 5/227

(54) **OPTICAL MODULE**

(71) Applicant: NTT, Inc., Tokyo 100-8116 (JP)
(72) Inventor: KANAZAWA, Shigeru, Musashino-shi, Tokyo 180-8585 (JP); KOBAYASHI, Wataru, Musashino-shi, Tokyo 180-8585 (JP); CHIN, Meishin, Musashino-shi, Tokyo 180-8585 (JP); KOSUGA, Shohei, Musashino-shi, Tokyo 180-8585 (JP)
(74) Representative: Hoffmann Eitle
(86) International application number: PCT/JP2023/022126
(87) International publication number: WO 2024/257277

(57) **Abstract**

An optical module includes an optical semiconductor chip, a subcarrier, and an electrode bonding portion electrically connecting the optical semiconductor chip and the subcarrier. The optical semiconductor chip includes an optical waveguide, a first stress relaxing groove and a second stress relaxing groove disposed along the optical waveguide so as to sandwich the optical waveguide when viewed from above the optical semiconductor chip, and a p-type electrode and an n-type electrode disposed so as to sandwich the first stress relaxing groove and the second stress relaxing groove. The electrode bonding portion is connected to the p-type electrode and the n-type electrode, and each of the first stress relaxing groove and the second stress relaxing groove is deeper than a core portion of the optical waveguide.

## Description

### TECHNICAL FIELD

The present disclosure relates to an optical module.

### BACKGROUND ART

Non Patent Literature 1 discloses a chip of a distributed feedback (DFB) laser in which both p-type and n-type electrodes are disposed on a chip upper surface. The chip is flip-chip mounted on a subcarrier, and an underfill material is poured into a gap between the subcarrier and the chip to fix the chip, thereby forming an optical module. The underfill material suppresses breakage of the electrode bonding portion due to stress caused by a difference in thermal expansion coefficient between the chip and the subcarrier.

### CITATION LIST

### NON PATENT LITERATURE

[Non Patent Literature 1] A. Marinins et. al., "Wafer-Scale Hybrid Integration of InP DFB Lasers on Si Photonics by Flip-Chip Bonding With sub-300 nm Alignment Precision," J of Sel. In Quantum Electronics, vol. 29, no. 3, 8200311.

### SUMMARY OF THE INVENTION

### TECHNICAL PROBLEM

With the optical module described in Non Patent Literature 1, in order to electrically bond a chip to a subcarrier, a bonding method such as solder, a conductive adhesive, or ultrasonic bonding is used. In these bonding methods, bonding is performed at a high temperature, and thereafter, when the temperature returns to room temperature, the bonding portion between the chip and the subcarrier contracts, and stress may be generated. There is a problem that the characteristics of the chip may change, such as shift of the oscillation wavelength of the laser, due to the stress generated in the bonding portion.

The present disclosure has been made in view of the above problem. An object thereof is to provide an optical module in which a characteristic fluctuation of a chip is suppressed when the chip is electrically bonded to a subcarrier.

### SOLUTION TO PROBLEM

In order to solve the above-described problem, an optical module according to one aspect of the present disclosure includes an optical semiconductor chip, a subcarrier, and an electrode bonding portion electrically connecting the optical semiconductor chip and the subcarrier. The optical semiconductor chip includes an optical waveguide, a first stress relaxing groove and a second stress relaxing groove disposed along the optical waveguide so as to sandwich the optical waveguide when viewed from above the optical semiconductor chip, and a p-type electrode and an n-type electrode disposed so as to sandwich the first stress relaxing groove and the second stress relaxing groove. The electrode bonding portion is connected to the p-type electrode and the n-type electrode, and each of the first stress relaxing groove and the second stress relaxing groove is deeper than a core portion of the optical waveguide.

### ADVANTAGEOUS EFFECTS OF INVENTION

According to the present disclosure, it is possible to provide an optical module in which a characteristic fluctuation of a chip is suppressed when the chip is electrically bonded to a subcarrier.

### BRIEF DESCRIPTION OF DRAWINGS

[Fig. 1] Fig. 1 is a top view of an optical semiconductor chip included in an optical module according to a first embodiment of the present disclosure.
[Fig. 2] Fig. 2 is a cross-sectional view taken along line A-A of the optical semiconductor chip of Fig. 1.
[Fig. 3] Fig. 3 is a layout diagram of an electrode bonding portion with respect to the optical semiconductor chip of Fig. 1.
[Fig. 4] Fig. 4 is a side view of the optical module according to the first embodiment of the present disclosure.
[Fig. 5] Fig. 5 is a top view of an optical semiconductor chip included in an optical module according to a second embodiment of the present disclosure.

### DESCRIPTION OF EMBODIMENTS

Next, embodiments of the present disclosure will be described in detail with reference to the drawings. In the description, the same components are denoted by the same reference signs, and redundant description will be omitted.

### [Description of First Embodiment]

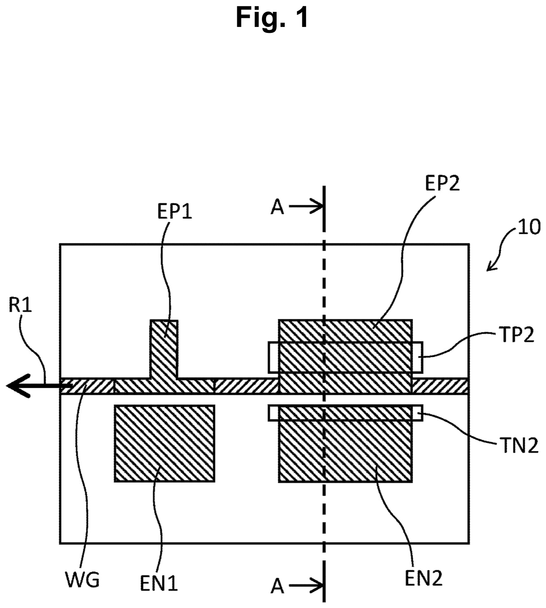

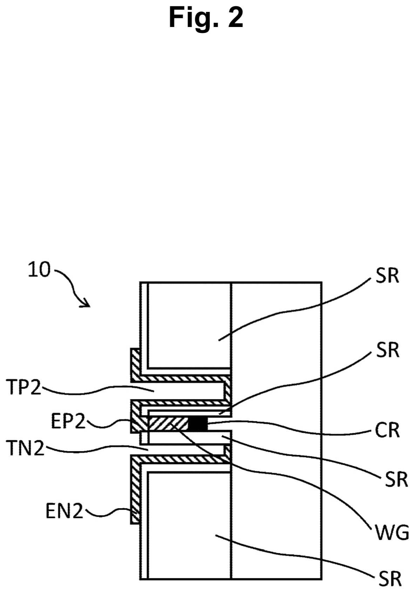

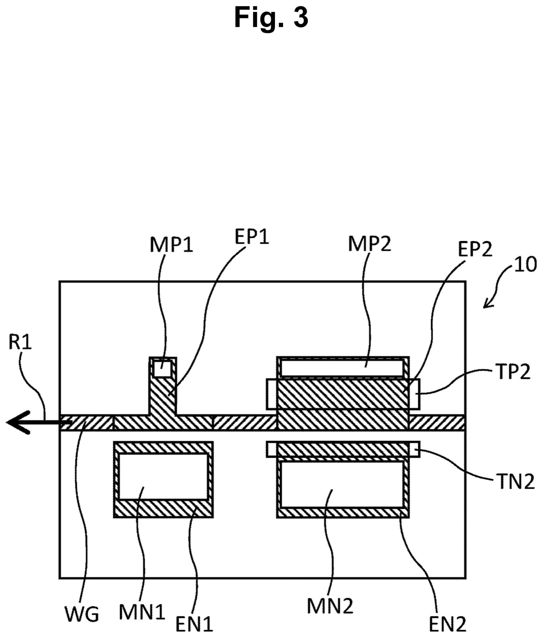

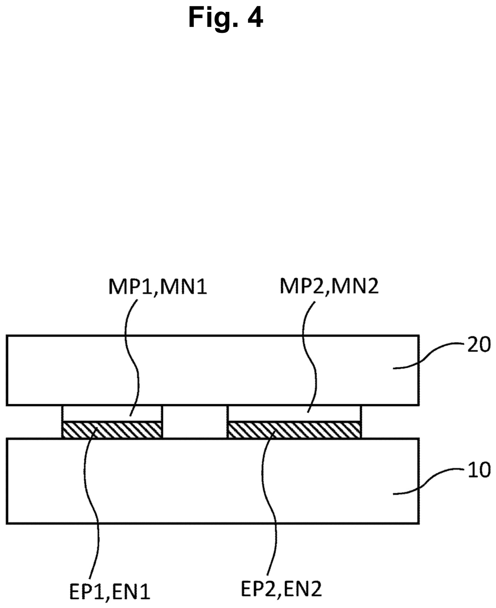

Fig. 1 is a top view of an optical semiconductor chip included in an optical module according to a first embodiment of the present disclosure. Fig. 2 is a cross-sectional view taken along line A-A of the optical semiconductor chip of Fig. 1. Fig. 3 is a layout diagram of an electrode bonding portion with respect to the optical semiconductor chip of Fig. 1. Fig. 4 is a side view of the optical module according to the first embodiment of the present disclosure. The optical module includes an optical semiconductor chip 10, a subcarrier 20, and an electrode bonding portion.

The optical semiconductor chip 10 is at least one of a direct modulation DFB laser chip and an electroabsorption optical modulator integrated laser chip. For example, the optical semiconductor chip 10 is a chip formed on an indium phosphide (InP) substrate. Light (output light R1) output from the optical semiconductor chip 10 is introduced into an optical wave circuit, which is not illustrated. The optical semiconductor chip 10 is not limited to the examples described herein.

The subcarrier 20 incorporates wiring for supplying power to the optical semiconductor chip 10 or wiring for transmitting a signal from the optical semiconductor chip 10. For example, the subcarrier 20 is made of aluminum nitride as a substrate and gold as a wiring pattern. The subcarrier 20 is not limited to the examples described herein.

Additionally, the thermal expansion coefficient of the subcarrier 20 may be equal to the thermal expansion coefficient of the optical semiconductor chip 10. This suppresses breakage of the electrode bonding portion due to stress caused by a difference in thermal expansion coefficient between the optical semiconductor chip 10 and the subcarrier 20.

As illustrated in Figs. 1 and 2, the optical semiconductor chip 10 includes an optical waveguide WG, a stress relaxing groove TP2 (first stress relaxing groove), a stress relaxing groove TN2 (second stress relaxing groove), p-type electrodes EP1 and EP2, and n-type electrodes EN1 and EN2. Here, the stress relaxing grooves TP2 and TN2 are disposed along the optical waveguide WG so as to sandwich the optical waveguide WG when viewed from above the optical semiconductor chip 10. In Fig. 1, the stress relaxing grooves TP2 and TN2 are disposed along the extending direction of the optical waveguide WG. The stress relaxing groove TP2 may also serve as a groove for leading out the p-type electrode EP2. The stress relaxing groove TN2 may also serve as a groove for leading out the n-type electrode EN2.

The p-type electrode EP2 is disposed on the upper surface of the optical semiconductor chip 10 on the side opposite to the optical waveguide WG across the stress relaxing groove TP2. In addition, the n-type electrode EN2 is disposed on the upper surface of the optical semiconductor chip 10 on the side opposite to the optical waveguide WG across the stress relaxing groove TN2.

As illustrated in Fig. 2, it can be seen that the n-type electrode EN2, the stress relaxing groove TN2, the optical waveguide WG, the stress relaxing groove TP2, and the p-type electrode EP2 are arranged in this order in the cross section of the optical semiconductor chip 10 perpendicular to the extending direction of the optical waveguide WG. Note that the optical waveguide WG may include a core portion CR, and both side surfaces of the core portion CR are embedded with a semi-insulating semiconductor SR.

The p-type electrodes EP1 and EP2 and the n-type electrodes EN1 and EN2 are electrically connected to wiring incorporated in the subcarrier 20 via an electrode bonding portion. Here, the electrode bonding portion is at least one of solder, a conductive adhesive, and metal.

For example, a conductive adhesive is applied to these electrodes of the optical semiconductor chip 10, and the optical semiconductor chip 10 is flip-chip mounted on the subcarrier 20. The p-type electrodes EP1 and EP2 and the n-type electrodes EN1 and EN2 are electrically connected to the wiring incorporated in the subcarrier 20. In addition to the conductive adhesive, electrical connection may be obtained using solder, metal, or adhesion by ultrasonic bonding.

Additionally, each of the stress relaxing grooves TP2 and TN2 is formed deeper than the core portion CR of the optical waveguide WG. In addition, the stress relaxing grooves TP2 and TN2 are formed longer along the extending direction of the optical waveguide WG than a laser portion (not illustrated) of the optical semiconductor chip 10.

In order to confirm an effect obtained by providing the stress relaxing grooves TP2 and TN2, an optical semiconductor chip 10 not provided with the stress relaxing grooves TP2 and TN2 was prepared as a comparative example. Then, the optical semiconductor chip 10 illustrated in Figs. 1 and 2 was compared with the comparative example.

Note that, as a condition for comparison, the optical semiconductor chip 10 is an electroabsorption optical modulator integrated laser chip and is a chip formed on an InP substrate. In addition, the subcarrier 20 is made of aluminum nitride as a substrate. In addition, gold-tin solder was used as an electrode bonding portion.

The optical module was assembled by mounting the optical semiconductor chip 10 such that the upper surface of the optical semiconductor chip 10 on which the electrode was disposed was in contact with the wiring side surface of the subcarrier 20, heating them at 320 degrees equal to or higher than the melting point of gold-tin solder, holding them for about 30 seconds, and cooling them to room temperature.

When an oscillation wavelength of the optical semiconductor chip 10 illustrated in Figs. 1 and 2 before being mounted on the subcarrier 20 was measured, the oscillation wavelength was 1308.1 nm at a chip temperature of 25 degrees and a laser current value of 100 mA. In addition, when the oscillation wavelength after mounting on the subcarrier 20 was measured, the oscillation wavelength was 1308.3 nm under the same operating condition. That is, the shift of the oscillation wavelength was 0.2 nm.

On the other hand, in the comparative example, when the oscillation wavelength before mounting on the subcarrier 20 was measured, the oscillation wavelength was 1306.5 nm at a chip temperature of 25 degrees and a laser current value of 100 mA. In addition, when the oscillation wavelength after mounting on the subcarrier 20 was measured, the oscillation wavelength was 1305.0 nm under the same operating condition. That is, the shift of the oscillation wavelength was 1.5 nm.

From the above results, it was confirmed that the fluctuation of the oscillation wavelength generated by the stress can be suppressed with the optical semiconductor chip and the optical module according to the present embodiment as compared with the optical semiconductor chip according to the comparative example.

### [Description of Second Embodiment]

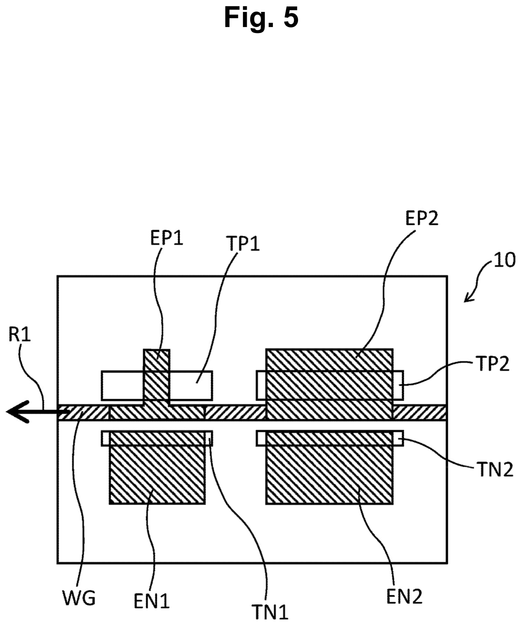

Fig. 5 is a top view of an optical semiconductor chip included in the optical module according to a second embodiment of the present disclosure. As compared with Fig. 1, in the optical semiconductor chip included in the optical module according to the present embodiment, a stress relaxing groove TP1 (first stress relaxing groove) and a stress relaxing groove TN1 (second stress relaxing groove) are further provided. The stress relaxing groove TP1 may also serve as a groove for leading out a p-type electrode EP1. The stress relaxing groove TN1 may also serve as a groove for leading out an n-type electrode EN1.

In order to confirm an effect obtained by providing the stress relaxing grooves TP1 and TN1, an optical semiconductor chip not provided with the stress relaxing grooves TP1 and TN1 was prepared as a comparative example. Then, the optical semiconductor chip 10 illustrated in Fig. 5 was compared with the comparative example.

Note that, as a condition for comparison, the optical semiconductor chip 10 is an electroabsorption optical modulator integrated laser chip and is a chip formed on an InP substrate. In addition, the subcarrier 20 is made of aluminum nitride as a substrate. In addition, a gold bump and a conductive adhesive were used as the electrode bonding portion.

After the conductive adhesive was applied to the wiring surface of the subcarrier 20, the optical semiconductor chip 10 was mounted such that the upper surface of the optical semiconductor chip 10 on which the electrode was disposed was in contact with the wiring side surface of the subcarrier 20. Thereafter, the optical module was assembled by holding at 150 degrees, which is the curing temperature of the conductive adhesive, for about 20 minutes and then cooling.

When an oscillation wavelength of the optical semiconductor chip 10 illustrated in Fig. 5 before being mounted on the subcarrier 20 was measured, the oscillation wavelength was 1550.4 nm at a chip temperature of 25 degrees and a laser current value of 120 mA. In addition, when the oscillation wavelength after mounting on the subcarrier 20 was measured, the oscillation wavelength was 1550.7 nm under the same operating condition. That is, the shift of the oscillation wavelength was 0.3 nm.

On the other hand, in the comparative example, when the oscillation wavelength before mounting on the subcarrier 20 was measured, the oscillation wavelength was 1545.5 nm at a chip temperature of 25 degrees and a laser current value of 120 mA. In addition, when the oscillation wavelength after mounting on the subcarrier 20 was measured, the oscillation wavelength was 1546.9 nm under the same operating condition. That is, the shift of the oscillation wavelength was 1.4 nm.

From the above results, it was confirmed that the fluctuation of the oscillation wavelength generated by the stress can be suppressed with the optical semiconductor chip and the optical module according to the present embodiment as compared with the optical semiconductor chip according to the comparative example.

The extinction characteristic of an EA modulator included in the optical semiconductor chip 10, which is an electroabsorption optical modulator integrated laser chip, was measured.

As for the optical semiconductor chip 10 illustrated in Fig. 5, when optical output power at bias voltages of 0 V and -2.5 V of the EA modulator was measured at a chip temperature of 25 degrees and a laser current value of 120 mA at a stage before mounting on the subcarrier 20, a difference in optical output power was 12.0 dB. At a stage after mounting on the subcarrier 20, the difference in optical output power was 11.9 dB under the same operating condition.

On the other hand, as for the comparative example, when optical output power at bias voltages of 0 V and -2.5 V of the EA modulator was measured at a chip temperature of 25 degrees and a laser current value of 120 mA at a stage before mounting on the subcarrier 20, a difference in optical output power was 13.0 dB. At a stage after mounting on the subcarrier 20, the difference in optical output power was 14.0 dB under the same operating condition.

From the above results, it was confirmed that the fluctuation of the extinction characteristic of the EA modulator generated by the stress can be suppressed with the optical semiconductor chip and the optical module according to the present embodiment as compared with the optical semiconductor chip according to the comparative example.

### [Effects of Embodiments]

As described above in detail, the optical module according to the present embodiment includes an optical semiconductor chip, a subcarrier, and an electrode bonding portion electrically connecting the optical semiconductor chip and the subcarrier. The optical semiconductor chip includes an optical waveguide, a first stress relaxing groove and a second stress relaxing groove disposed along the optical waveguide so as to sandwich the optical waveguide when viewed from above the optical semiconductor chip, a p-type electrode disposed on an upper surface of the optical semiconductor chip on a side opposite to the optical waveguide across the first stress relaxing groove, and an n-type electrode disposed on the upper surface of the optical semiconductor chip on a side opposite to the optical waveguide across the second stress relaxing groove. The electrode bonding portion is connected to the p-type electrode and the n-type electrode, and each of the first stress relaxing groove and the second stress relaxing groove is deeper than a core portion of the optical waveguide.

As a result, it is possible to provide an optical module in which a characteristic fluctuation of a chip is suppressed when the chip is electrically bonded to a subcarrier. In particular, since the first stress relaxing groove and the second stress relaxing groove are deeper than the core portion of the optical waveguide, the stress generated at the electrode bonding portion is prevented from being transmitted to the core portion of the optical waveguide. As a result, the characteristic fluctuation of the chip is suppressed.

In addition, in the optical module according to the present embodiment, the optical semiconductor chip may further include a laser portion, and each of the first stress relaxing groove and the second stress relaxing groove may be longer than the laser portion. Thus, the stress generated at the electrode bonding portion is prevented from being transmitted to the laser portion. As a result, the shift of the oscillation wavelength of the laser is suppressed.

Further, in the optical module according to the present embodiment, the optical semiconductor chip is at least one of a direct modulation DFB laser chip and an electroabsorption optical modulator integrated laser chip, so that high frequency characteristics of the direct modulation DFB laser chip and the electroabsorption optical modulator integrated laser chip can be improved, and wavelength stability can be increased.

In addition, in the optical module according to the present embodiment, both side surfaces of the core portion may be embedded with a semi-insulating semiconductor. Thus, the core portion is insulated from the p-type electrode and the n-type electrode disposed in the vicinity. As a result, the fluctuation of the characteristics of the core portion is suppressed.

Further, in the optical module according to the present embodiment, the p-type electrode and the n-type electrode may be electrically connected to the wiring incorporated in the subcarrier via the electrode bonding portion, and the electrode bonding portion may be at least one of solder, a conductive adhesive, and metal. Thus, the electrical connection between the electrodes of the optical semiconductor chip 10 and the wiring incorporated in the subcarrier can be secured.

In addition, in the optical module according to the present embodiment, the thermal expansion coefficient of the subcarrier may be equal to the thermal expansion coefficient of the optical semiconductor chip. Thus, when the optical semiconductor chip is mounted on the subcarrier, stress due to a difference in thermal expansion coefficient between the optical semiconductor chip and the subcarrier is suppressed. As a result, breakage of the electrode bonding portion between the optical semiconductor chip and the subcarrier is suppressed.

Although the contents of the present disclosure have been described above according to the embodiments, the present disclosure is not limited to the description thereof, and it is obvious to those skilled in the art that various modifications and improvements can be made. It should not be construed that the present disclosure is limited to the statements and the drawings that constitute a part of the present disclosure. Various alternative embodiments, examples, and operating techniques will be apparent to those skilled in the art from this disclosure.

It is needless to say that the present disclosure includes various embodiments and the like that are not described herein. Accordingly, the technical scope of the present disclosure is defined only by the invention-specifying matters according to the claims appropriate from the above description.

### REFERENCE SIGNS LIST

- CR: Core portion
- EN1, EN2: n-type electrode
- EP1, EP2: p-type electrode
- TP1, TP2, TN1, TN2: Stress relaxing groove
- WG: Optical waveguide
- 10: Optical semiconductor chip
- 20: Subcarrier

## Claims

1. An optical module comprising:
an optical semiconductor chip;
a subcarrier; and
an electrode bonding portion that electrically connects the optical semiconductor chip and the subcarrier, wherein
the optical semiconductor chip includes
an optical waveguide,
a first stress relaxing groove and a second stress relaxing groove disposed along the optical waveguide so as to sandwich the optical waveguide when viewed from above the optical semiconductor chip,
a p-type electrode disposed on an upper surface of the optical semiconductor chip on a side opposite to the optical waveguide across the first stress relaxing groove, and
an n-type electrode disposed on the upper surface of the optical semiconductor chip on a side opposite to the optical waveguide across the second stress relaxing groove,
the electrode bonding portion is connected to the p-type electrode and the n-type electrode, and
each of the first stress relaxing groove and the second stress relaxing groove is deeper than a core portion of the optical waveguide.

2. The optical module according to claim 1, wherein
the optical semiconductor chip further includes a laser portion, and
each of the first stress relaxing groove and the second stress relaxing groove is longer than the laser portion.

3. The optical module according to claim 1, wherein the optical semiconductor chip is at least one of a direct modulation distributed feedback laser chip and an electroabsorption optical modulator integrated laser chip.

4. The optical module according to claim 1, wherein both side surfaces of the core portion are embedded with a semi-insulating semiconductor.

5. The optical module according to claim 1, wherein
the p-type electrode and the n-type electrode are electrically connected to wiring incorporated in the subcarrier via the electrode bonding portion, and
the electrode bonding portion is at least one of solder, a conductive adhesive, and metal.

6. The optical module according to any one of claims 1 to 5, wherein a thermal expansion coefficient of the subcarrier is equal to a thermal expansion coefficient of the optical semiconductor chip.
